# EUROPEAN PATENT APPLICATION

(11) **EP 4 270 512 A1**
(43) Date of publication of application: **01.11.2023**
(21) Application number: 22461539.3
(22) Date of filing: 25.04.2022
(51) Int. Cl.: H01L 51/42

(54) **A PEROVSKITE STRUCTURE, A PHOTOVOLTAIC CELL, AND A METHOD FOR PREPARATION THEREOF**

(71) Applicant: Fundacja Saule Research Institute, 54-427 Wroclaw (PL)
(72) Inventor: Wilk, Barbara, 50-217 Wroclaw (PL); Ivanovska, Tanja, 50-502 Wroclaw (PL); Wojciechowski, Konrad, 52-016 Wroclaw (PL)
(74) Representative: Kancelaria Eupatent.pl Sp. z.o.o

(57) **Abstract**

A perovskite structure for optoelectronic applications, the perovskite structure comprising a stack of layers, the stack of layers comprising: a perovskite layer made of CsPb(I₁₋ₓBrₓ)₃, the perovskite layer being deposited directly on a functional layer 14, 24 comprising a cesium salt component consisting of at least one cesium salt selected from the group consisting of CsBr, CsCI, Csl, CsF, (CH3COO)Cs, (HCOO)Cs, and CsSCN, wherein the total amount of the cesium salt component in the functional layer 14, 24 is not less than 0.1 wt% based on the total mass of the functional layer.

## Description

### TECHNICAL FIELD

The present disclosure relates to a perovskite structure comprising an absorber inorganic-perovskite CsPb(I₁₋ₓBrₓ)₃ layer, a photovoltaic (PV) cell comprising the perovskite structure, and a method for preparing the perovskite structure. The structure exhibits improved stability of the perovskite CsPb(I₁₋ₓBrₓ)₃ phase, and it is suitable to be used in the production of PV (solar) cell of improved stability.

### BACKGROUND

The photovoltaic devices composed of PV (solar)cells generate electrical power by converting light into electricity, using materials that exhibit the photovoltaic effect. Among them, there are known various perovskite modules build up from a plurality of electrically connected PV cells comprising, within their structures, a perovskite light-active material, being either pure organic or pure inorganic, or mixed organic-inorganic perovskite material, sandwiched by two electrodes - a transparent-to-light front electrode and, typically, non-transparent counter electrode, also called a back electrode, preferably made from metals or metal alloys, or carbon. Between the perovskite material and each of the electrodes, the cell can comprise functional layers of materials to enhance the performance and/or stability of the PV device. The functional layers may include charge-transporting layers, e.g. electron transport layer (ETL) and/or hole transport layer (HTL), seeding layers - typically arranged for perovskite growth, barrier layers, etc. Among the perovskite PV (solar cells), there are known thin-film planar structures of p-i-n and n-i-p architecture. In the n-i-p planar structures, the solar cell is illuminated through ETL side whereas in the p-i-n planar structure, the solar cell is illuminated through HTL side.

In some of the PV cells architectures, the seeding layer can be arranged between the electron transport layer (ETL) and the perovskite. The employment of the seeding layer can provide various benefits. *Inter alia*, US10573690 describes a seeding layer made of perovskite material - CH₃NH₃PbBr₃ for growing organic-inorganic perovskite: CH₃NH₃Pbl₃. The involvement of this seeding layer aims to stabilize the perovskite phase. However, the emerged mechanism of phase stabilization (using CH₃NH₃PbBr₃) cannot be straightforwardly transferred into the formation of purely inorganic perovskite light active layers. Further, CN111739961 describes an inorganic solar cell with a tin oxide seed layer comprising ordered SnO₂ nanorod arrays deposited on the surface of the conductive substrate. Within this structure, an inorganic perovskite layer is deposited within gaps of the nanorods as well as on nanorods surfaces, wherein the obtained structure exhibits improved charge transfer. Moreover, US10950781 describes a two-dimensional perovskite nanosheet seed layer made of TiO₂, Ti_{0,91}O₂, Ti_{0,87}O₂, Ti₃O₇, Ti₄O₉, Ti₅O₁₁ , MnO₂, Mn₃O₇, Nb₃O₈, Nb₆O₁₇, LaNb₂O₇, La_{0,90}Eu_{0,05}Nb₂O₇, Eu_{0,56}Ta₂O₇, SrTa₂O₇, Bi₂SrTa₂O₉, Ca₂Nb₃O₁₀, Sr₂Nb₃O₁₀, NaCaTa₃O₁₀, CaLaNb₂TiO₁₀, La₂Ti₂NbO₁₀, Ba₅Ta₄O₁₅, W₂O₇, RuO_{2,1}, Cs₄W₁₁O₃₆, TaO₃, TiNbO₅, Ti₂NbO₇, and/or TiTaOs. This enables one to prepare a piezoelectric thin film, having improved piezoelectric characteristics, and a perovskite crystal structure - oriented in a specific direction, which is formed on a substrate (with a low transition temperature) by a low-temperature process.

Further, a photo-active inorganic perovskite material - CsPbX₃, where X typically represents I or Br, or a mix of both - in various ratios, is known to be used in optoelectronic devices. Particularly, the perovskite - CsPbl₃ presents good potential for the inorganic PV cells, due to its narrow bandgap around 1,7 eV, low nonradiative recombination, and good transport properties. CsPbl₃ can take various crystal structures (polymorphs) including cubic (α), tetragonal (β) and orthorhombic (γ) (which are the perovskite black phases - optically active).

However, the potential of CsPbl₃ material cannot be fully developed because of the low stability of the optically active perovskite black CsPbl₃ phases. The perovskite CsPbl₃ phases are not stable at room temperature, and transform into orthorhombic δ-CsPbl₃ (also called yellow phase) - which is non-perovskite, optically non-active, phase. The yellow phase has one of the lowest free energy of formation in the case of CsPbl₃. If the temperature is increased, the optically non-active phase - δ-CsPbl₃ can be directly converted into a perovskite (photo-active) black phase. Typical annealing temperatures in order to achieve the perovskite black phase ranges about 200°C. Thereby, even though the black phase of the iodide perovskites is able to prevail after their corresponding synthesis, the unavoidable formation of metastable phases occurs after the cooling process and during their storage.

Thereby, the preservation of the perovskite CsPbl₃ black phase at room temperatures is challenging, limiting its applications in the PV cells. This further limits the choice of materials for the PV cells comprising CsPbl₃. E.g. the use of thermoplastic flexible substrate materials, non-resistive to temperatures of perovskite CsPbl₃ - annealing, is limited in the production of the PV modules.

Various attempts have been taken to overcome at least some of the above-mentioned drawbacks, including different approaches aiming at stabilization the perovskite CsPbl₃ phase, at lower temperatures. CN113035991 describes a method for preparation of CsPbl₃ perovskite layer, which involves incorporating CsBr, within the formed perovskite layer (CsPbl₃). The addition of CsBr ensures stabilization of the inorganic perovskite at lower temperatures. However, this inevitably leads to bromine atoms (from CsBr) incorporation into the perovskite lattice, resulting in a change in the perovskite composition and, thereby, the bandgap of the material.

A method for preparing low-temperature perovskite CsPbl₃ black phase is described in the scientific article *"*Low Temperature Synthesis of Stable γ-CsPbl3 Perovskite Layers for Solar Cells Obtained by High Throughput Experimentation" Pascal Becker et al. Advanced Energy Materials, Vol.9, Issue 22, June 12, 2019. The preparation of stable perovskite γ-CsPbl₃ lies in providing Csl-rich growth conditions for phase stabilization. The obtained perovskite layer does not need a high-temperature post-treatment, including post-deposition annealing. However, this approach requires an introduction of excessive Csl into the perovskite lattice which may have a negative impact on the optical properties of the material.

### SUMMARY OF THE INVENTION

There is a need to overcome at least some of the drawbacks discussed in the background section and to provide a perovskite structure and a PV cell having integrated said perovskite structure, comprising the perovskite CsPb(I₁₋ₓBrₓ)₃ black phase of improved stability at room temperature.

In one aspect of the present invention, there is provided a perovskite structure for optoelectronic applications, the perovskite structure comprising a stack of layers, the stack of layers comprising: a substrate, a functional layer, an electrode deposited between the substrate and the functional layer, and a perovskite layer made of CsPb(I₁₋ₓBrₓ)₃, wherein x is a value of from 0 to 0.1, the perovskite layer being deposited directly on the functional layer, wherein the functional layer comprises a cesium salt component consisting of at least one cesium salt selected from the group consisting of CsBr, CsCI, Csl, CsF, (CH3COO)Cs, (HCOO)Cs, and CsSCN, wherein the total amount of the cesium salt component in the functional layer is not less than 0.1wt% based on the total mass of the functional layer.

Due to the presence of the cesium salt component in the functional layer, and due to that the functional layer is in direct contact with the perovskite layer, the black perovskite CsPb(I₁₋ₓBrₓ)₃ phase is stabilized - namely, the black perovskite CsPb(I₁₋ₓBrₓ)₃ phase is less prone to transition into the non-perovskite yellow phase (δ) and it persists longer in ambient conditions, at room temperature.

Preferably, the total amount of the cesium salt component in the functional layer is not less than 95 wt% based on the total mass of the functional layer.

If the functional layer is almost entirely made of the cesium salt component, it functions as a seeding medium enabling the preparation of the perovskite layer made of black perovskite CsPb(I₁₋ₓBrₓ)₃ phase, in lower temperatures, i. e. not exceeding 120°C, and preferably not exceeding 100°C. Also, the seeding functionality of the functional layer contributes to the preservation of the black perovskite CsPb(I₁₋ₓBrₓ)₃ phase, at room temperature.

Preferably, the perovskite structure further comprises an electron transport layer deposited between the electrode and the functional layer.

In this configuration, the material of the electron transport layer is not interfered by the presence of the functional layer. Also, the electron transport layer does not affect the stabilization of the black perovskite CsPb(I₁₋ₓBrₓ)₃ phase by the cesium salt component of the functional layer.

Preferably, the functional layer has a thickness of 0.1 to 20 nm.

Such the thickness allows for the functional layer to provide sufficient coverage and seeding centers for the growth of the perovskite, while still allowing for unimpaired electron charge transport.

Optionally, preferably, the functional layer is mainly composed of a matrix material being an electron transport material (ETM), said functional layer comprising the cesium salt component in the amount of 0.1 to 25 wt% based on the total content of the matrix material in the functional layer, wherein the cesium salt component constitutes an additive to the matrix material, dispersed in the matrix material.

The cesium salt component - as the additive, does not interfere chemical structures of the matrix material; the cesium salt component is dispersed within the matrix material. This adds additional activity to the functional layer, depending on the specific choice of the matrix material being an electron transport material (ETM). The functional layer provides stabilization of the black perovskite CsPb(I₁₋ₓBrₓ)₃ phase due to the presence of dispersed particles of the cesium salt component in the amount of 0.1 to 25wt% based on the total content of the ETM in the functional layer, wherein the matrix material can add another functionality - it serves as the electron transport material.

Preferably, the matrix material consists of at least one compound selected from the group consisting of SnO₂, ZnO, TiO₂, ZnSnO₄, fullerene of electron transporting properties, and fullerene derivatives of electron transporting properties.

This adds additional activity to the functional layer. The functional layer provides stabilization of the perovskite CsPb(I₁₋ₓBrₓ)₃ phase due to the presence of dispersed particles of the cesium salt component in the amount of 0.1 to 25wt% based on the content of the matrix material, and simultaneously the matrix material acts as the electron transporting material selected from the above-mentioned group. Thereby the functional layer acts as both the seeding layer and ETL of an appropriate electron transporting parameters.

Preferably, the functional layer (24) has a thickness of 1 to 150 nm.

This thickness allows for efficient electron transport while acting as a blocking layer for the transport of holes in the role of an ETL. At the same time, the functional layer provides seeding properties for the perovskite layer.

In another aspect of the present invention, there is provided a PV cell, comprising the perovskite structure described above, wherein said cell further comprises a counter electrode deposited on the perovskite layer.

The PV cell features improved stability of the photo-active perovskite layer. This is achieved due to the direct contact of the functional layer comprising the hygroscopic cesium salt component providing stabilization of the black perovskite CsPbl₃ phase. Within this structure the black perovskite CsPb(I₁₋ₓBrₓ)₃ phase is less prone to transition to non-perovskite yellow phase(δ), thereby, it persists longer in ambient conditions, at room temperature.

Preferably, said cell is arranged as a n-i-p structure comprising the substrate made of a light-transmissive material, the electrode made of at least one transparent conductive oxide (TCO) and the counter electrode made of at least one metal or carbon material.

This provides improved efficiency of the module.

Preferably, said cell further comprises a hole transport layer deposited between the counter electrode and the perovskite layer.

The presence of the hole transport layer provides further improved efficiency of the PV cell.

In yet another aspect of the present invention, there is provided a method for producing a black perovskite CsPb(I₁₋ₓBrₓ)₃ phase, comprising the steps of: providing a functional layer comprising a cesium salt component consisting of at least one cesium salt selected from the group consisting of CsBr, CsCI, Csl, CsF, (CH3COO)Cs, (HCOO)Cs and CsSCN, wherein the total amount of the cesium salt component in the functional layer is not less than 0.1wt% based on the total mass of the functional layer, directly on the functional layer, applying a perovskite-forming solution comprising a perovskite CsPb(I₁₋ₓBrₓ)₃ wherein x is a value of from 0 to 0.1, or precursors of said perovskite, dissolved in an evaporable solvent, the solvent being evaporable at a temperature of the perovskite crystallization, and treating the applied perovskite-forming solution by heating the perovskite-forming solution at a temperature not exceeding 120°C until crystalizing the black perovskite CsPb(I₁₋ₓBrₓ)₃ phase.

The application of the perovskite-forming solution on the functional layer comprising the hygroscopic cesium salt component(s) allows to crystalize the perovskite at a substantially low temperature - not exceeding 120°C, and more preferably not exceeding 100°C with the formation of black perovskite CsPb(I₁₋ₓBrₓ)₃ phase, without the need of further annealing. Obtained this way the perovskite layer shows improved stability, including thermodynamic stability at room temperature. Further, obtained this way black perovskite CsPb(I₁₋ₓBrₓ)₃ phase does not undergo, or at least it is less prone to undergo phase transition to non-perovskite phase, even upon longer storage, at room temperature.

Preferably, the perovskite-forming solution comprises of 10 to 50wt% of the perovskite CsPb(I₁₋ₓBrₓ)₃ dissolved in the evaporable solvent constituting at least one compound selected from the group consisting of N,N-dimethylformamide (DMF), dimethyl sulfoxide (DMSO), γ-Butyrolactone (GBL), and 2-methoxyphenol (2MP).

This composition of the perovskite-forming solution provides the formation of the required perovskite thin film as well as the required thickness of the perovskite layer, and optimal concentration of the perovskite-forming materials as well as optimal rheological properties for wet deposition with variety of techniques.

Preferably, the step of providing the functional layer is accomplished by: on a base surface, applying a solution comprising the cesium salt component and an evaporable solvent to form a coating made of the solution, and drying the coating made of the solution to obtain the functional layer, by evaporating the evaporable solvent.

Further using the solution comprising the cesium salt component to form the functional layer, provides substantial freedom to use the cesium salt component serving as an additive to the solutions of various compositions, such as different solutions of electron transport materials.

Preferably, the base surface is an electron transport layer, and the solution substantially consists of the cesium salt component, dissolved in the evaporable solvent, present in the solution at the concentration of 0.1 - 75wt%, wherein the total amount of the cesium salt component in the obtained functional layer is not less than 95 wt% based on the total mass of the functional layer.

This enables the preparation of the functional layer in a form almost entirely made of the cesium salt component - serving as a seeding substrate and enabling the preparation of the perovskite layer made of black perovskite CsPb(I₁₋ₓBrₓ)₃ phase, in lower temperatures, i. e. not exceeding 120°C, and preferably not exceeding 100°C. Also, the seeding functionality of the functional layer contributes to the preservation of the black perovskite CsPb(I₁₋ₓBrₓ)₃ phase.

Optionally preferably, the base surface is an electrode, and the solution substantially consists of a matrix material being an electron transport material (ETM) present in the solution at the concentration of 0.3 to 10wt% and the cesium salt component present in the solution at the concentration of 0.1 to 25wt% with respect to ETM, dissolved in the evaporable solvent, wherein the obtained functional layer is mainly composed of the matrix material and comprises the cesium salt component in the amount of 0.1 to 25 wt% based of the content of the matrix material in the functional layer, wherein, in the functional layer, the cesium salt component is dispersed in the matrix material.

Using the solution with the cesium salt component(s) - as the additive, provides that the cesium salt component(s) does not interfere with chemical structures of the matrix material being the electron transport material constituting another solution ingredient; thereby both materials: the electron transport and cesium salt component(s) can be deposited to form the layer at once, saving time and energy spend at whole preparation process. Further, this provides additional activity to the obtained functional layer, which exhibits both stabilization of the black perovskite CsPb(I₁₋ₓBrₓ)₃ phase (due to the presence of dispersed cesium salt component particles) and transport of electrons.

### BRIEF DESCRIPTION OF DRAWINGS

Aspects and features of the present invention will become apparent by describing, in detail, exemplary embodiments of the present invention with reference to the attached drawings, in which:
Figs 1, 2 present schematically a perovskite structure according to two embodiments of the present disclosure;
Figs 3A - 3F presents the PV cell in six embodiments comprising the perovskite structure according to the present disclosure;
Fig. 4 presents X-ray diffraction measurement of perovskite films deposited on different functional layers and on unmodified SnO₂, annealed at 100°C;
Fig. 5 presents X-ray measurement of perovskite layer crystallized on the functional layer made of CsCI, measured over time (storing conditions in nitrogen and in ambient conditions - in air with 25% relative humidity, at room temperature.

### DETAILED DESCRIPTION OF EMBODIMENTS

Reference will now be made to embodiments, examples of which are illustrated in the accompanying drawings. Aspects and features of the invention will be described with reference to the accompanying drawings. In the drawings, like reference numerals denote like elements. The present invention, however, may be embodied in various different forms and should not be construed as being limited only to the illustrated embodiments. Rather, the presented embodiments are provided as example so that this disclosure will be thorough and complete, and will fully convey the aspects and features of the present invention to those skilled in the art. It shall be understood that not all of the features shown in the embodiment are essential and the scope of the protection is defined not by means of literally shown embodiment, but by the features provided in the claims.

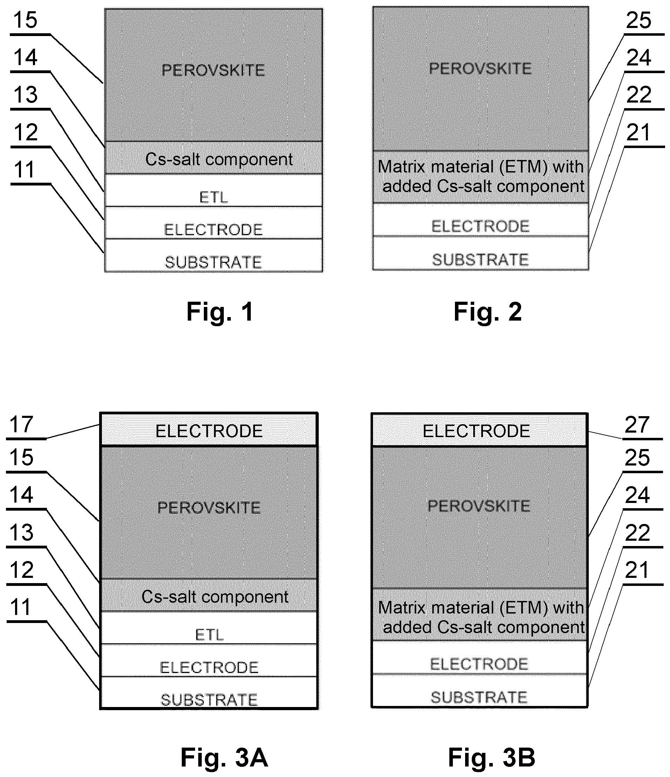

Figs. 1 -2 present schematically two embodiments of a perovskite structure in a cross-section. The perovskite structure comprises a substrate 11, 21, a front electrode 12, 22 deposited on the substrate 11, 21, a functional layer 14, 24 comprising cesium calt component in an amount not less than 0.1wt%based on the total mass of the functional layer 14, 24, and a perovskite layer 15, 25 deposited directly on the functional layer 14, 24. Also, the perovskite structure may further comprise a charge transport layer 13, preferably the electron transport layer 13 sandwiched by the substrate 11 and the functional layer 14, as schematically shown in Fig. 1. Furthermore, the functional layer 24 may be adapted to act, as the charge transport layer, and preferably as the electron transport layer 24, comprising an electron transport material (ETM) schematically shown in Fig. 2.

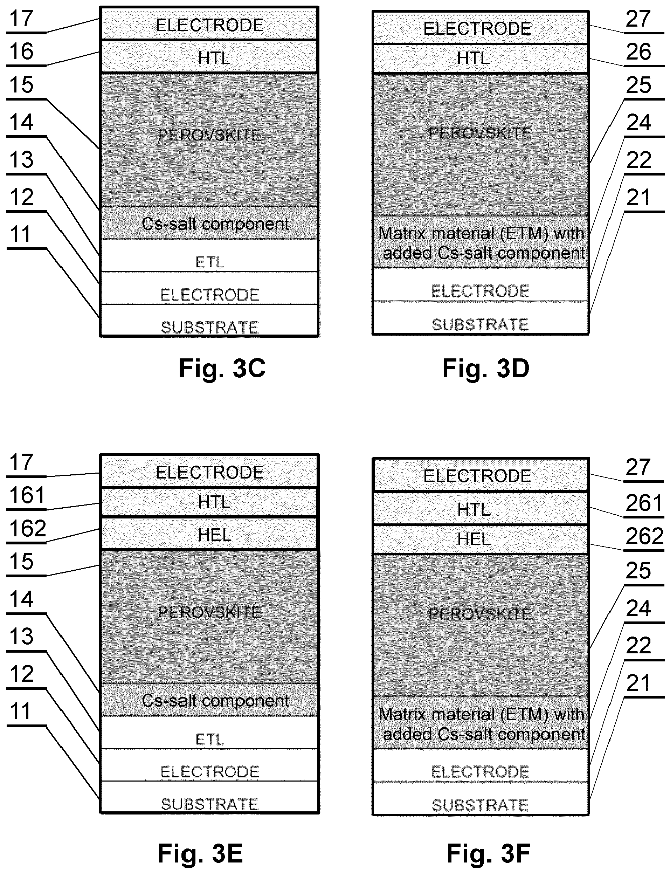

The perovskite structure is configured to be integrated within the structure of a PV cell as schematically shown in Fig 3A - 3F. The PV cell, comprising the perovskite structure according to the present disclosure, can be provided with a counter electrode layer 17, 27 deposited either directly on the perovskite layer 15, 25 of the perovskite structure (Figs. 3A, 3B) or on an optional additional layer 16, 26 preferably in a form of a charge transfer layer, such as hole transport layer 16, 26 (Figs. 3C, 3D), or in a form of a stack of layers (instead of one additional layer 16, 26), said stack can comprise e.g. a hole transport layer and a hole extraction layer 161, 162, 261, 261 respectively, sandwiched by the perovskite layer 15, 25 of the perovskite structure and the counter electrode layer 17, 27, as schematically shown in Fig 3E and 3F. The PV cell having integrated the perovskite structure can be further configured to be positioned such that the substrate 11, 21 of the perovskite structure is exposed to light, e.g sunlight, at the installation spot, and more preferably the PV cell, comprising the perovskite structure, has planar n-i-p structure.

The substrate 11, 21 can be made of various materials, preferably light-transmitting either flexible or non-flexible plastics, such as flexible or non-flexible thermoplastics materials, e.g., at least one material selected from the group consisting of PET (poly(ethylene terephthalate)), PEN ((poly(ethylene 2,6-naphthalate)), PETFE (poly(ethene-co-tetrafluoroethene)), PMMA (poly(methyl methacrylate)) and/or PI (polyimide). Alternatively, the substrate 11, 21 may be made of glass. The flexible thermoplastic materials, such as PET, are especially suitable for the substrate 11, 21 as they allow the whole PV module (i.e. the cell structure embedded on the common substrate) flexibility. Thereby, applications of PV modules incorporating the perovskite structure, are not restricted to rigid surfaces such as roofs or building facades. The PV module can be exploited on non-rigid surfaces such as furniture and/or fabrics in general, e.g. furniture upholstery, windows treatments, etc.

The front electrode layer 12, 21 is preferably made of e.g. transparent conductive electrode (TCO), such as indium tin oxide (ITO), fluorine-doped tin oxide (FTO), aluminum-doped zinc oxide (AZO) and/or indium zinc oxide (IZO).

The perovskite layer 15, 25 comprises inorganic perovskite: CsPbI₁₋ₓBrₓ)₃, wherein x is a value of from 0 to 0.1 or preferably the perovskite layer 15, 25 is substantially entirely made of CsPb(I₁₋ₓBrₓ)₃, wherein x is a value of from 0 to 0.1, or more preferably the perovskite layer 15, 25 is entirely made of CsPb(I₁₋ₓBrₓ)₃, wherein x = 0 (i.e. CsPbl₃). Non-limiting exemplary embodiments of the inorganic perovskite of the perovskite layer 15, 25 are CsPbl₃, CSPb(I_{0.95}Br_{0.05})₃, CsPb(I_{0.9}Br_{0.1})₃, CsPbI_{0.03}Br_{0.02})₃. The use of CsPbl₃ - as the inorganic material of the perovskite layer 15, 25 - is especially suitable because of its operational and structural stability.

The perovskite layer 15, 25 is directly deposited on the functional layer 14, 24 which serves as a perovskite-growth medium, during the preparation of the perovskite layer 15, 25.

In some embodiments of the perovskite structure, the functional layer 24 is substantially made of a matrix material. Preferably, the matrix material consists of an electron transport material (ETM); preferably the ETM, being the matrix material of the functional layer 24, is selected from the group consisting of SnO₂, TiO₂, ZnO, ZnSnO₄, fullerene of electron transporting properties, such as e.g. fullerene (C60), and/or fullerene derivatives of electron transporting properties such as e.g. [6, 6]-phenyl-C61-butyric acid methyl ester (PCBM).

The matrix material of the functional layer 24 comprises an additive of one or more hygroscopic cesium salt component (cesium salt component) in the amount not exceeding 25wt% based on the content of the matrix material in the functional layer 24, and more preferably the functional layer 24 comprises the additive of one or more hygroscopic cesium salt component in the amount of 0.1 to 25 wt% based on the content of the matrix material in the functional layer 24. For said amount, the hygroscopic cesium salt component constitutes an addition that does not build into the structure (e.g. lattice) of the matrix material of the functional layer 24 e.g. it does not impact the crystal lattice of the matrix material. In other words, the additive of hygroscopic cesium salt component together with the matrix material of the functional layer 24 does not create a new material of the matrix. Preferably the hygroscopic cesium salt component is selected from the group consisting of CsBr, CsCI, Csl, CsF, (CH₃COO)CS, (HCOO)Cs and/or CsSCN. The thickness of the functional layer 24 preferably ranges from 1 to 150 nm.

In another embodiment of the perovskite structure, the functional layer 14 is substantially entirely or, more preferably, entirely made of one or more than one hygroscopic cesium salt component (cesium salt component). In this embodiment, the functional layer 14 comprises at least 95 wt% of the hygroscopic cesium salt component, e.g. the functional layer 14 can comprise: 95 wt% of the hygroscopic cesium salt component, 96 wt% of the hygroscopic cesium salt component, 97 wt% of the hygroscopic cesium salt component, 98 wt% of the hygroscopic cesium salt component, 99 wt% of the hygroscopic cesium salt component, or 100 wt% of the hygroscopic cesium salt component, based on the total mass of the functional layer 14, the latter means that in one embodiment the functional layer 14 can be entirely made of the hygroscopic cesium salt component. Preferably, the hygroscopic cesium salt component is selected from the group consisting of CsBr, CsCI, Csl, CsF, (CH₃COO)CS, (HCOO)Cs and/or CsSCN. The thickness of the functional layer 14 preferably ranges from 0,1 to 20 nm.

The term *'hygroscopic cesium salt component'* used herein denotes cesium salt component that is able to absorb water; the cesium salt component suitable to be used according to the present disclosure includes cesium salts selected from CsBr, Csl, CsCI CsF, (CH₃COO)Cs (cesium acetate), (HCOO)Cs (cesium formate) and/or CsSCN (cesium thiocyanate).

The implementation of the hygroscopic cesium salt component as the additive dispersed in the matrix material of the functional layer 24, or implementation of the hygroscopic cesium salt component as that substantially entirely building the functional layer 14, is believed to provide certain acceleration to the inorganic perovskite nucleation step, which eases the formation of black, CsPb(I₁₋ₓBrₓ)₃ perovskite phase, and provides a noticeable and measurable effect of stabilization of the formed black perovskite CsPb(I₁₋ₓBrₓ)₃ phase (i.e. light-active phase) at room temperature. Further, the functional layer 14, 24, used as a direct medium for preparation of the perovskite CsPb(I₁₋ₓBrₓ)₃ layer 15, 25 enables the perovskite CsPb(I₁₋ₓBrₓ)₃ phase to be formed (during the perovskite layer deposition) at a substantially low temperature not exceeding 120°C, and more preferably not exceeding 100°C, without annealing post-treatment of the perovskite. Preferably, the obtained perovskite layer 15, 25 can have a thickness of 100 to 700 nm, exhibiting improved stability. The presence of the functional layer 14, 24 is supposed to facilitate a nucleation stage of the perovskite CsPb(I₁₋ₓBrₓ)₃ phase at a temperature not exceeding 120°C, providing this way measurable improvement in the stability of the black perovskite CsPb(I₁₋ₓBrₓ)₃ phase, at room temperature. Thereby, the obtained effect differs from a simple obtainment of a perovskite structure with improved moisture tolerance.

Furthermore, according to the present disclosure, the facilitated preparation of the perovskite layer 15, 25 can be accomplished at substantially low temperatures, without additional modification of the perovskite precursors composition, and no modification of the perovskite CsPb(I₁₋ₓBrₓ)₃ lattice is achieved - without perovskite crystal lattice inclusions, modifiers or stabilizers. The obtained perovskite layer 15, 25 can comprise a pure structure of CsPbl₃ of a desired narrow bandgap of 1.7-1.8 eV. Also, the perovskite CsPb(I₁₋ₓBrₓ)₃ wherein 0<x≤0.1, can comprise a very low amount of Br; for CsPb(I₁₋ₓBrₓ)₃ where x = 0.1, the amount of Br in the perovskite corresponds to 10%. This percentage of Br, in the perovskite, induces small changes in the lattice which will not significantly change the band gap and will not result in the change in the performance values of the PV cell.

The perovskite structure, as well as the PV cell comprising thereof, can constitute an inorganic-perovskite alternative of the known organic-inorganic hybrid perovskite PV cell and PV modules, exhibiting improved stability at room temperatures and featuring desired narrow bandgap of the light-active material.

### Preparation method:

The method for preparation of the perovskite structure can comprise depositing the electrode 12, 22 on the substrate 11, 21 - preferably properly cleaned and activated in advance, optionally followed by depositing, on the electrode 12, 22, another suitable layer(s) such as the ETL 13. Alternatively, the method can utilize the substrate 11, 21 with already deposited thereon, the desired layers 12, 22 and optionally 13.

The functional layer 14, 24 is formed on a base surface which e.g. can be either the electrode 12, 22 or the following (upper) layer, such as the ETL 13. The step of formation of the functional layer 14, 24 may employ technique(s) of process deposition, for example, spin-coating, blade coating, and/or inkjet printing, as well as technique(s) of thermal evaporation or deposition by another technique which allows the layer formation of the thickness of 0.1 to 150 nm.

In one embodiment the formation of the functional layer 24 involves deposition of a solution of the matrix material mixed with the addition of the hygroscopic cesium salt component. The solution may comprise a dispersion of the matrix material having a concentration in the solution of 0.3 to 10 wt%. The matrix material is preferably the electron transport material (ETM) e.g. SnO₂, TiO₂, ZnO, and/or fullerene(s). In said solution, the concentration of the cesium salt component with respect to the ETM preferably amounts of 0.1 to 25wt%. A solvent comprised in the solution is evaporable at the temperature from the range of 50 to 200 °C. The evaporable solvent may constitute one compound, or a mixture of two or more compounds, being polar or apolar (protic or aprotic) solvent, such as water, alcohols and/or ethers. At depositing of the functional layer 24, the solution is applied on the desired base surface, e.g. the electrode 22, to coat the base surface with a wet coating of the solution. e.g. by using spin coating, or another suitable solution process technique that allows obtaining the desired layer thickness; for example the layer thickness of 1 - 150 nm (the thickness after drying), such as blade coating, inject printing, slot die coating, etc. Next, the wet coating is dried, e.g. on a hot plate, or in an oven, preferably at the drying temperature not exceeding 100°C, for the time suitable to dry, e.g. for 20 minutes (at 100°C). This method allows one to obtain the functional layer 24 comprising the matrix material being the electron transport material, as shown in Fig. 2, and the addition of hygroscopic cesium salt component. In this embodiment, the functional layer 24 can serve as both the ETL and the layer enhancing the following formation of the black perovskite CsPb(I₁₋ₓBrₓ)₃ phase. Thus, for this particular embodiment of the perovskite structure, the implementation of another ETL (i.e. other than that provided by the functional layer 24) is not necessary.

In another embodiment, the formation of the functional layer 14 involves depositing a solution of hygroscopic cesium salt component in an evaporable solvent preferably water, ethanol or water/ethanol-mixture solvent, having a concentration of cesium salt component preferably of 0.1 - 75wt% and more preferably of 0.3 to 10 wt%, and more preferably 0.5 to 10 wt%. The solution is applied on the desired base surface (e.g. the electrode layer 12, 22 or the ETL 13) for coating the surface with the solution. The suitable coating technique(s) are those enabling one to achieve, the desired functional layer thickness, for example, the functional layer thickness of 0.1 to 20 nm, including spin coating, spray-coating, blade coating, inkjet printing, and/or slot die coating, etc. Next, the wet coating is dried, e.g. on a hot plate or in an oven, preferably at the drying temperature not exceeding 100°C, for the time that allows the wet coating to dry, e.g. for 10 minutes (at 100°C).

In the next step, the perovskite layer 15, 25 is deposited directly on the dried functional layer 14, 24.

The deposition of the perovskite layer 15, 25 involves applying a perovskite-forming solution being a solution of CsPb(I₁₋ₓBrₓ)₃ in a suitable solvent, such as N,N-dimethylformamide (DMF), dimethyl sulfoxide (DMSO), γ-Butyrolactone (GBL) and/or 2-methoxyphenol (2MP), having a concentration of CsPb(I₁₋ₓBrₓ)₃ ranging from 10 to 50 wt%. Alternatively, the deposition of the perovskite layer 15, 25 can involve applying the perovskite-forming solution being a solution of perovskite precursors: lead salt - Pbl₂ or PbBr₂ and cesium salt - Csl or CsBr. The molar ratio between lead salts and cesium salt can vary from 1:1 mol ratio to 1:1.3 mol ratio (excess of Cs). The ratio between iodide and bromide salt can be varied to provide desired bromide content in the final composition of CsPb(I₁₋ₓBrₓ)₃. The salts can be dissolved in DMF or DMF:DMSO mixture or another solvent such as that listed above. The perovskite-forming solution for the perovskite layer 15, 25 can further comprise one or more additives such as functional additives preferably in the total amount of 0.1 to 6wt% with respect to Pb content. The exemplary additive is ascorbic acid in 5wt% with respect to Pb content in said solution, further examples of the additives are 4-fluoro-phenethylammonium iodide (4-FPEAI), phenethylammonium iodide (PEAI), and dimethylammonium iodine (DMAI). The overall concentration of solids in the solution for the perovskite layer can vary from 10 to 50wt%.

The application of the perovskite-forming solution can be accomplished by any of the known technique(s) that allows the perovskite-forming solution to coat the functional layer 14, 24 and to obtain the target thickness, e.g. of 100 - 700 nm of the perovskite layer 15, 25 (measured after crystallization of the perovskite). The suitable technique(s) may include spin coating (e.g. with the spinning rate of 1000 to 3000 rpm), blade coating, inject printing, and/or slot die coating, etc. Next, the obtained wet coating of the perovskite-forming solution is subjected to crystallization at the temperature of 80 - 120 °C, for the time enabling crystallizing of the black perovskite phase CsPb(I₁₋ₓBrₓ)₃, preferably ranging of 5 - 60 min. The exact time required for crystallization depends on the perovskite-forming solution wet coating thickness and the crystallization temperature. The crystallization can take place for example on a hot plate or in an oven. After the crystallization, the obtained perovskite layer is ready-to-use - the obtained perovskite does not require post-crystallization annealing.

The step of depositing the functional layer 14, 24 as well as the step of depositing the perovskite layer 15, 25 can be performed under ambient conditions, i.e. the temperature of 20 - 30°C (except the drying and crystallization, for which the temperatures are defined above), in the atmosphere of air, and Relative Humidity (RH) of 1 to 60%.

The above method allows for obtaining the perovskite layer 15, 25, consisting of black perovskite CsPb(I₁₋ₓBrₓ)₃ phase, deposited on the functional layer 14, 24 either entirely made of hygroscopic cesium salt component or made from the matrix material preferably being the electron transport material with the addition of the cesium salt component.

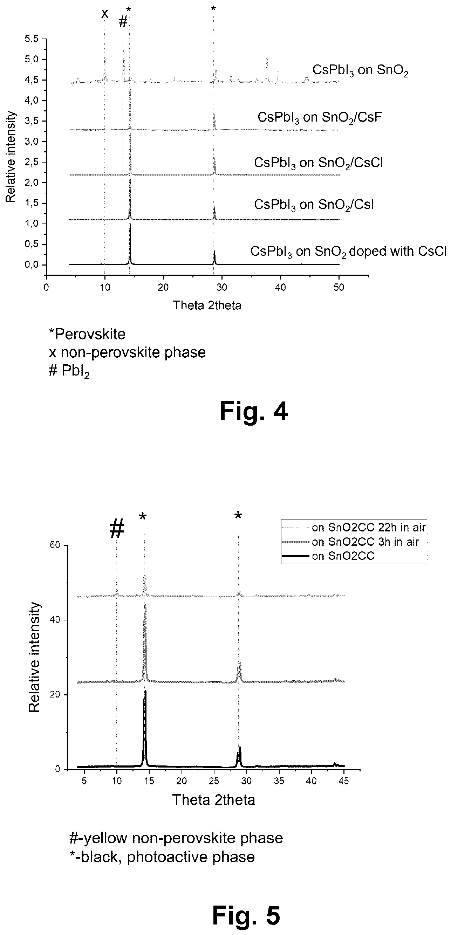

Fig. 4 shows X-ray measurement taken for the following perovskite structures: the structures comprising ETL made of SnO₂ coated with the functional layer made of CsF, CsCI, and Csl, respectively, the structure with the functional layer being ETL (SnO₂) with the addition of CsCI; each of the structures comprising perovskite CsPbl₃ layer. For the comparison, there is also added spectrum of a structure having the ETL (SnO₂) without the cesium salt component. As follows from Fig. 4 the black perovskite CsPbl₃ phase is present on all the functional layers, while only the non-perovskite phase (δ) is present when the perovskite is deposited directly on top of ETL made of SnO₂ without the addition of hygroscopic cesium salt component.

Furthermore, Fig. 5 shows X-ray measurement presenting the stability of the black perovskite CsPbl₃ phase according to the present disclosure (the measurements taken at 0, 3^{rd}, and 22^{th} hour, in air). As follows from Fig. 5, once the black perovskite CsPbl₃ phase is formed directly on the functional layer the perovskite does not undergo phase transition to non-perovskite yellow phase, upon prolonged storage, in air, at room temperature. Thus, the thermodynamic stability of the perovskite layer obtained by the method according to the present disclosure is enhanced.

Additionally, the developed process for the formation of the perovskite layer 15, 25 allows the use of temperature-sensitive materials (such as flexible plastic materials for the substrate 11, 21) for the production of the perovskite structure as well as the PV cells, and PV modules comprising said perovskite structure. This is because the developed method for black perovskite CsPb(I₁₋ₓBrₓ)₃ formation does not require post-crystallization annealing at higher temperatures.

### EMBODIMENT 1 - perovskite structure comprising functional layer entirely made of hygroscopic cesium salt component;

### Preparation of the perovskite structure:

### a) Substrate preparation:

The substrate: PET/ITO of thickness 150um/100nm, was cleaned using dry cleaning (however wet cleaning can be used instead), and next activated using plasma activation (UV-O₃ can be used instead).

### b) ETL deposition:

Next, PET/ITO was coated with 5wt% SnO₂ aqueous dispersion using a spin coating (blade coating, inkjet printing, or slot die coating can be used instead). The wet film of SnO₂ aqueous dispersion was dried on the hot plate at 100°C for 20 minutes. The obtained dried ETL had a thickness of 30 nm.

### c) Functional layer deposition (serving as seeding layer) prepared using solution process:

30 mg of cesium salt component: CsCI was dissolved in 1 mL of water. The obtained solution (30 mg/ml) was deposited on top of SnO₂ layer (ETL) using spin coating: the CsCI solution was applied on the ETL (30ul of the CsCI solution per 1cm² of the ETL surface) and coated using spin coating at 3000 rpm for 30 s. The obtained wet film was dried at the hot plate for 10 min at 100 °C. The obtained functional layer has a thickness of around 2 nm.

### d1) Perovskite layer deposition (CsPbI₃, x=0):

Solution of inorganic perovskite:
0.17g of Csl, 0.31g of Pbl₂ and 0.024g of ascorbic acid were dissolved in 1ml of DMF. The concentration of the obtained solution was 35wt%

The 35wt% CsPbl₃ in DMF was deposited on top of the prepared functional layer, using spin-coating. Next, the wet film was subjected to crystallization on the hot plate for around 20 min at 120°C (the crystallization can be accomplished in an oven instead). The obtained perovskite CsPbl₃ layer after the crystallization had a thickness of 350 nm.

### d2) Perovskite layer deposition (CsPb(I₁₋ₓBrₓ)₃; x≠0).

Solution of inorganic perovskite:
0.17g of Csl, 0.31g of Pbl₂, 0.01g of PbBr₂ and 0.024g of ascorbic acid were dissolved in 1ml of DMF. The concentration of the obtained solution was 35wt%

The 35wt% CsPb(I₁₋ₓBrₓ)₃ in DMF was deposited on top of the prepared functional layer, using spin-coating. Next, the wet film was subjected to crystallization on the hot plate for around 20 min at 120°C (the crystallization can be accomplished in an oven instead). The obtained perovskite CsPbl₃ layer after the crystallization had a thickness of 350 nm.

All the steps a - d (either d1 or d2) (solution processes) took place in ambient conditions: an atmosphere of air, T= 23- 25°C, RH=30% (except the drying and the crystallization, for which the temperatures are described above).

### Preparation of the PV cell:

### e) Back (counter) electrode deposition:

In order to fabricate a fully working PV cell, a carbon electrode was deposited directly on top of the perovskite layer of the perovskite structure, prepared in steps a - d, using the rod-coating technique. After deposition, the counter electrode layer was dried using IR lamp for 3 min.

Alternatively, HTL (hole transport layer) material (e.g. spiro-o-Me-TAD) can be deposited on top of the perovskite layer using the solution process method (such as spin-coating), and the carbon electrode can be deposited (as described above) on top of HTL. Instead of the carbon electrode, on the HTL, a metallic electrode (e.g. silver or gold) can be deposited by the thermal evaporation technique.

Thereby the whole PV cell is obtained according to the steps a - e, above, wherein the PV module (consisting of a plurality of PV cells) can be achieved by using the desired patterning between the respective steps (a - e).

### EMBODIMENT 2 - perovskite structure comprising functional layer, adapted as ETL, with the additive of hygroscopic cesium salt component;

### a) Substrate preparation:

The substrate: PET/ITO (of thickness 150um/100nm) was cleaned using dry cleaning (however wet cleaning can be used instead), and next activated using plasma activation (UV-O₃ can be used instead).

### b) Functional layer deposition

A commercial dispersion of 15wt% SnO₂ in water was diluted with water 1:2 v/v and 20 mg of CsCI per one ml of SnO₂ dispersion was added to the dispersion. The obtained solution was applied on the surface of PET/ITO and coated using spin-coating at a spinning rate 2000 rpm. The wet film was dried on the hot plate at 100 °C for 20 minutes. The obtained functional layer had a thickness of 30 nm. The obtained functional layer was aimed to serve as both the seed surface for the perovskite growth and ETL.

### c1) Perovskite deposition (CsPbl₃; x=0):

Solution of inorganic perovskite:
0.17g of Csl, 0.31g of Pbl₂ and 0.024g of ascorbic acid dissolved in 1ml of DMF. The concentration of the obtained solution was 35wt%.

The 35wt% CsPbl₃ in DMF was deposited on top of the prepared functional layer, using spin-coating. Next, the wet film was subjected to crystallization on the hot plate for around 20 min at 120 °C (the crystallization can be accomplished in an oven instead). The obtained perovskite CsPbl₃ layer after the crystallization had a thickness of 150 nm.

### c2) Perovskite layer deposition (CsPb(I₁₋ₓBrₓ)₃; x≠40).

Solution of inorganic perovskite:
0.17g of Csl, 0.31g of Pbl, 0.01g of PbBr₂ and 0.024g of ascorbic acid dissolved in 1ml of DMF. The concentration of the obtained solution was 35wt%.

The 35wt% CsPb(I₁₋ₓBrₓ)₃ in DMF was deposited on top of the prepared functional layer, using spin-coating. Next the wet film was subjected to crystallization on the hot plate for around 20 min at 120 °C (the crystallization can be accomplished in an oven instead). The obtained perovskite CsPbl₃ layer after the crystallization had a thickness of 350 nm.

All the steps a - c (either c1 or c2) (solution processes) took place in ambient conditions: an atmosphere of air, T= 23-25°C, RH=30% (except the drying and the crystallization, for which the temperatures are described above).

### d) Back (counter) electrode deposition:

In order to fabricate a fully working PV cell, a carbon electrode was deposited directly on top of the perovskite layer of the perovskite structure, prepared in steps a - d, using the rod-coating technique. After deposition, the counter layer was dried using IR lamp for 3min.

Alternatively, HTL (hole transport layer) material (e.g. spiro-o-Me-TAD) can be deposited on top of the perovskite layer using the solution process method (such as spin-coating), and the carbon electrode can be deposited (as described above) on top of HTL. Instead of the carbon electrode, on the HTL, a metallic electrode (e.g. silver or gold) can be deposited by the thermal evaporation technique.

Thereby the whole PV cell is obtained according to the steps a - e, Embodiment 1 (or a - d, Embodiment 2), above, wherein the PV module (consisting of a plurality of PV cells) can be achieved by using the desired patterning between the respective steps.

## Claims

1. A perovskite structure for optoelectronic applications, the perovskite structure comprising a stack of layers, the stack of layers comprising:
a substrate (11, 21),
a functional layer (14, 24),
an electrode (12, 22) deposited between the substrate (11,21) and the functional layer (14, 24), and
a perovskite layer made of CsPb(I₁₋ₓBrₓ)₃, wherein x is a value of from 0 to 0.1, the perovskite layer being deposited directly on the functional layer (14, 24),
wherein the functional layer (14, 24) comprises a cesium salt component consisting of at least one cesium salt selected from the group consisting of CsBr, CsCI, Csl, CsF, (CH3COO)Cs, (HCOO)Cs, and CsSCN,
wherein the total amount of the cesium salt component in the functional layer (14, 24) is not less than 0.1wt% based on the total mass of the functional layer.

2. The perovskite structure according to claim 1, wherein the total amount of the cesium salt component in the functional layer (14) is not less than 95 wt% based on the total mass of the functional layer.

3. The perovskite structure according to claim 2 wherein the perovskite structure further comprises an electron transport layer (13) deposited between the electrode (12) and the functional layer (14).

4. The perovskite structure according to claim 2 or 3 wherein the functional layer (14) has a thickness of 0.1 to 20 nm.

5. The perovskite structure according to claim 1, wherein the functional layer (24) is mainly composed of a matrix material being an electron transport material (ETM), said functional layer (24) comprising the cesium salt component in the amount of 0.1 to 25 wt% based on the total content of the matrix material in the functional layer (24), wherein the cesium salt component constitutes an additive to the matrix material, dispersed in the matrix material.

6. The perovskite structure according to claim 5 wherein the matrix material consists of at least one compound selected from the group consisting of SnO₂, ZnO, TiO₂, ZnSnO₄, fullerene of electron transporting properties, and fullerene derivatives of electron transporting properties.

7. The perovskite structure according to claim 5 or 6, wherein the functional layer (24) has a thickness of 1 to 150 nm.

8. A PV cell, comprising the perovskite structure according to any of the preceding claims, wherein said cell further comprises a counter electrode (17, 27) deposited on the perovskite layer (15, 25).

9. The PV cell according to claim 8 wherein said cell is arranged as a n-i-p structure comprising the substrate (11, 21) made of a light-transmissive material, the electrode (12, 22) made of at least one transparent conductive oxide (TCO) and the counter electrode (17, 27) made of at least one metal or carbon material.

10. The PV cell according to claim 8 or 9 wherein said cell further comprises a hole transport layer (16, 26) deposited between the counter electrode (17, 27) and the perovskite layer (15, 25).

11. A method for producing a black perovskite CsPb(I₁₋ₓBrₓ)₃ phase, comprising the steps of:
- providing a functional layer (14, 24) comprising a cesium salt component consisting of at least one cesium salt selected from the group consisting of CsBr, CsCI, Csl, CsF, (CH₃COO)CS, (HCOO)Cs and CsSCN, wherein the total amount of the cesium salt component in the functional layer (14, 24) is not less than 0.1wt% based on the total mass of the functional layer (14, 24),
- directly on the functional layer (14, 24), applying a perovskite-forming solution comprising
a perovskite CsPb(I₁₋ₓBrₓ)₃ wherein x is a value of from 0 to 0.1, or
precursors of said perovskite,
dissolved in an evaporable solvent, the solvent being evaporable at a temperature of the perovskite crystallization, and
- treating the applied perovskite-forming solution by heating the perovskite-forming solution at a temperature not exceeding 120°C until crystalizing the black perovskite CsPb(I₁₋ₓBrₓ)₃ phase.

12. The method according to claim 11 wherein the perovskite-forming solution comprises of 10 to 50wt% of the perovskite CsPb(I₁₋ₓBrₓ)₃ dissolved in the evaporable solvent constituting at least one compound selected from the group consisting of N,N-dimethylformamide (DMF), dimethyl sulfoxide (DMSO), γ-Butyrolactone (GBL), and 2-methoxyphenol (2MP).

13. The method according to claim 11 or 12 wherein the step of providing the functional layer (14, 24) is accomplished by:
- on a base surface, applying a solution comprising the cesium salt component and an evaporable solvent to form a coating made of the solution, and
- drying the coating made of the solution to obtain the functional layer (14, 24), by evaporating the evaporable solvent.

14. The method according to claim 13 wherein the base surface is an electron transport layer (13), and the solution substantially consists of the cesium salt component, dissolved in the evaporable solvent, present in the solution at the concentration of 0.1 - 75wt%, wherein the total amount of the cesium salt component in the obtained functional layer (14) is not less than 95 wt% based on the total mass of the functional layer.

15. The method according to claim 13 wherein the base surface is an electrode (22), and the solution substantially consists of a matrix material being an electron transport material (ETM) present in the solution at the concentration of 0.3 to 10wt% and the cesium salt component present in the solution at the concentration of 0.1 to 25wt% with respect to ETM, dissolved in the evaporable solvent, wherein the obtained functional layer (24) is mainly composed of the matrix material and comprises the cesium salt component in the amount of 0.1 to 25 wt% based of the content of the matrix material in the functional layer (24),
and wherein, in the functional layer (24), the cesium salt component is dispersed in the matrix material.
